# EUROPÄISCHE PATENTSCHRIFT

(11) **EP 3 141 961 B1**
(45) Veröffentlichungstag und Bekanntmachung des Hinweises auf die Patenterteilung: **17.10.2018**
(21) Anmeldenummer: 16184526.8
(22) Anmeldetag: 17.08.2016
(51) Int. Cl.: G03F 7/20, G02B 26/10

(54) **BELEUCHTUNGSEINHEIT UND VORRICHTUNG ZUR LITHOGRAFISCHEN BELICHTUNG**
EXPOSURE UNIT AND DEVICE FOR LITHOGRAPHIC EXPOSURE
UNITE D'ECLAIRAGE ET DISPOSITIF D'ECLAIRAGE LITHOGRAPHIQUE

(30) Priorität: 08.09.2015 DE 102015115064
(43) Veröffentlichungstag der Anmeldung: 15.03.2017
(73) Patentinhaber: Fraunhofer-Gesellschaft zur Förderung der angewandten Forschung e.V., 80686 München (DE); Friedrich-Schiller-Universität Jena, 07743 Jena (DE)
(72) Erfinder: Zeitner, Uwe Detlef, 99423 Weimar (DE); Weichelt, Tina, 07745 Jena (DE); Bourgin, Yannick, 07745 Jena (DE)
(74) Vertreter: Epping - Hermann - Fischer

(56) Entgegenhaltungen:
- EP-A2- 2 253 997
- US-A- 4 497 015
- US-A- 5 307 207
- US-A1- 2008 151 206

## Beschreibung

Die Erfindung betrifft eine Beleuchtungseinheit zur lithografischen Belichtung und eine Vorrichtung zur lithografischen Belichtung mit einer derartigen Beleuchtungseinheit.

Für die Erzeugung von deterministischen Mikrostrukturen werden häufig lithografische Verfahren eingesetzt. Dabei wird eine strahlungsempfindliche Polymerschicht (Resist) mit einer lateral variierenden Dosisverteilung einer bestimmten Strahlungsart belichtet. Die eingebrachte Strahlungsdosis verändert die Polymereigenschaften in einer Weise, dass in einem anschließenden Entwicklungsschritt selektiv nur die bestrahlten (Positivresist) oder nur die unbestrahlten (Negativresist) Bereiche der Polymerschicht gelöst und damit entfernt werden.
In der Mikroelektronik und Mikrosystemtechnik verwendete Lithografiesysteme verwenden häufig einen sogenannten Mask Aligner (Maskenpositionierer), also eine Vorrichtung zur exakten Positionierung von Fotomasken. Dabei wird das Licht einer möglichst kurzwelligen Strahlquelle, beispielsweise einer Quecksilber-Hochdrucklampe, mit Hilfe einer Beleuchtungsoptik gesammelt und zur Beleuchtung einer vorgefertigten Fotomaske eingesetzt. Diese Fotomaske enthält die in die strahlungsempfindliche Polymerschicht zu belichtenden Strukturen in Form von transparenten und nicht transparenten Bereichen, die z. B. in eine dünne Chromschicht auf einem Maskensubstrat eingebracht sind. In den transparenten Bereichen wird die Chromschicht dazu selektiv entfernt. Mit einer solchen Fotomaske wird das Beleuchtungslicht beim Durchtritt durch die Fotomaske entsprechend moduliert. Die zu belichtende Polymerschicht befindet sich auf einem Substrat, welches in direkten Kontakt mit der Fotomaske gebracht wird (so genanntes Contact Printing) oder befindet sich in einem geringen Abstand von einigen Mikrometern zur Fotomaske (so genanntes Proximity Printing).
In den letzten Jahren wurden spezielle Mask-Aligner basierte Lithografieverfahren entwickelt, bei denen die Struktur nicht mehr durch einfachen Schattenwurf von der Maske in den Fotolack kopiert wird, sondern bei der gezielt Beugungseffekte an speziell berechneten Fotomaskenstrukturen zur Auflösungssteigerung bei der Belichtung des Fotolacks eingesetzt werden. Ein solches Verfahren ist zum Beispiel aus der Druckschrift T. Weichelt, U. Vogler, L. Stuerzenbecher, R. Voelkel, U.D. Zeitner, "Resolution enhancement for advanced mask aligner lithography using phase-shifting photomasks", Optics Express 22 (2014), 16310-16321, bekannt. Ein solches Verfahren wird auch als Beugungslithographie bezeichnet.

EP 2 253 997 A2 offenbart eine Beleuchtungseinheit zur lithographischen Belichtung mit einer Strahlquelle, einem Element zur Einstellung der Winkelverteilung in der Maskenebene (angle defining element), einem Strahlhomogenisierungselement, einer Fourierlinse und einer Feldlinse.

US 5 307 207 A offenbart eine Beleuchtungseinheit zur lithographischen Belichtung mit einer Strahlquelle, einem elektronisch ansteuerbaren Strahlablenkelement zur Erzeugung einer zeitlich variierenden zweidimensionalen Strahlablenkung, einer Kollimationslinse und einem Strahlhomogenisierungselement.

Insbesondere bei der Beugungslithographie stößt die konventionelle Beleuchtung mit Hg-Hochdrucklampen an Grenzen. Die beugungslithografischen Verfahren erfordern typischerweise eine Maskenbeleuchtung mit sehr geringer Restdivergenz der Beleuchtungswinkel. Dies lässt sich bei der konventionellen Beleuchtung nur durch eine Aperturblende mit sehr geringer Öffnung im Beleuchtungsstrahlengang realisieren. Durch die geringe Blendenöffnung sinkt jedoch die zur Verfügung stehende Lichtleistung so stark ab, dass unpraktikabel lange Belichtungszeiten die Folge sind. Aufgrund der Eigenschaften von Quecksilber-Hochdrucklampen (thermische Strahlquelle mit einem Quellvolumen im Bereich von mm³) ist dieses Problem kaum überwindbar.

Alternativ kann als Strahlquelle ein Laser eingesetzt werden, mit dem ein deutlich höherer Kollimationsgrad der Beleuchtung erreichbar ist. Allerdings führt die hohe Kohärenz von Lasern in einem konventionellen Beleuchtungsstrahlengang des Mask-Aligners zum Auftreten von örtlich hochfrequenten Interferenzmustern (so genannte Speckles), die lokal die Homogenität der Maskenbeleuchtung signifikant verschlechtern und zu unbrauchbaren Belichtungsergebnissen führen.

Eine zu lösende Aufgabe besteht somit darin, eine Beleuchtungseinheit und eine Vorrichtung zur lithografischen Belichtung anzugeben, welche die zuvor genannten Nachteile überwindet und eine homogene Maskenbeleuchtung mit einer definierten und gezielt einstellbaren Beleuchtungswinkelverteilung ermöglicht.

Diese Aufgaben werden durch eine Beleuchtungseinheit zur lithografischen Belichtung und eine Vorrichtung zur lithografischen Belichtung gemäß den unabhängigen Patentansprüchen gelöst. Vorteilhafte Ausgestaltungen und Weiterbildungen der Erfindung sind Gegenstand der abhängigen Ansprüche.

Gemäß zumindest einer Ausgestaltung umfasst die Beleuchtungseinheit zur lithografischen Belichtung eine Strahlquelle, wobei die Strahlquelle vorzugsweise eine LaserLichtquelle ist, ein elektronisch ansteuerbares Strahlablenkelement, dass zur zweidimensionalen Strahlablenkung geeignet ist, eine Kollimationslinse, ein Strahlhomogenisierungselement, eine Fourierlinse und eine Feldlinse, die zur telezentrischen Beleuchtung einer Fotomaske vorgesehen ist. Die angegebenen Elemente sind vorzugsweise in der genannten Reihenfolge im Strahlengang der Beleuchtungseinheit angeordnet. Dies schließt nicht aus, dass zwischen den genannten Elementen ein oder mehrere weitere Elemente angeordnet sein können. Beispielsweise kann zwischen der Strahlquelle und dem Strahlablenkelement ein polarisierendes optisches Element angeordnet sein.

Bei der Beleuchtungseinheit wird mittels des zweidimensionalen Strahlablenkelements vorteilhaft eine definierte Winkelverteilung in den Richtungen senkrecht zur optischen Achse erzeugt, beispielsweise in einer x-Richtung und einer y-Richtung, die orthogonal zueinander sind und jeweils senkrecht zur optischen Achse verlaufen. Insbesondere wird auf diese Weise das Licht der Strahlquelle mit einer gezielt eingestellten Winkelverteilung auf die dem Strahlablenkelement nachfolgende Kollimationslinse gerichtet. Beispielsweise kann mit dem Strahlablenkelement eine Winkelverteilung von jeweils bis zu ± 20° in x- und y-Richtung erzeugt werden.

Durch die dem Strahlablenkelement im Strahlengang nachfolgende Kollimationslinse wird die einfallende Strahlung mit der definierten Winkelverteilung kollimiert, d.h. derart abgelenkt, dass sie sich parallel zur optischen Achse ausbreitet. Die kollimierte Strahlung trifft nachfolgend auf ein Strahlhomogenisierungselement, das eine definierte Winkelverteilung erzeugt und vorteilhaft die Strahlung homogenisiert. Das Strahlhomogenisierungselement wirkt insbesondere als Diffusor. Im Fall einer Laserlichtquelle kann das Strahlhomogenisierungselement insbesondere ein örtlich hochfrequentes Interferenzmuster der Laserlichtquelle homogenisieren. Das Strahlhomogenisierungselement kann zum Beispiel eine Winkelverteilung von etwa ± 9° in x- und y-Richtung erzeugen.

Aus der mittels des Strahlhomogenisierungselements erzeugten Strahlung mit definierter Winkelverteilung wird mittels eines Linsensystems, dass eine Fourierlinse und eine Feldlinse umfasst, eine räumliche Intensitätsverteilung in der Ebene der Feldlinse erzeugt. Die Feldlinse hat die Funktion, in einer lithografischen Vorrichtung eine Fotomaske telezentrisch zu beleuchten. Durch das Linsensystem aus der Fourierlinse und der Feldlinse wird eine Fotomaske vorteilhaft vollständig ausgeleuchtet.

Das Strahlablenkelement ist vorteilhaft ein elektronisch ansteuerbares Strahlablenkelement, das eine zeitlich variierende Strahlablenkung in zwei Raumrichtungen erzeugt. Die zeitlich variierende Strahlablenkung projiziert den Strahl der Strahlquelle auf diese Weise auf eine Fläche, insbesondere auf die der Strahlquelle nachfolgende Kollimationslinse. Das Strahlablenkelement ist insbesondere ein scannendes Strahlablenkelement, das durch die zeitlich variierende Strahlablenkung eine Fläche ausleuchtet, die groß im Vergleich zum Strahldurchmesser der Strahlquelle ist.

Das Strahlablenkelement zur zweidimensionalen Strahlablenkung ist vorzugsweise ein 2D-Spiegelscanner, d.h. ein Spiegelscanner, der eine Strahlablenkung in zwei Achsen bewirken kann. Solche Spiegelscanner sind an sich bekannt und werden zum Beispiel in Projektionsvorrichtungen eingesetzt. Der Spiegelscanner kann zum Beispiel zwei durch einen Antrieb rotierbare Spiegel umfassen, wobei ein Spiegel eine Strahlablenkung in x-Richtung und ein zweiter Spiegel eine Strahlablenkung in y-Richtung bewirkt, wobei die x-Richtung und die y-Richtung senkrecht zueinander sind und insbesondere jeweils senkrecht zur optischen Achse verlaufen.

Bevorzugt ist der 2D-Spiegelscanner ein Galvanometer-Scanner, oder kurz Galvoscanner. Bei dem Galvanometer-Scanner werden die beiden Spiegel vorteilhaft durch einen galvanischen Antrieb bewegt. Ein Galvanometer-Scanner zeichnet sich dadurch aus, dass die Spiegel mit einer hohen Geschwindigkeit bewegt werden können. Beispielsweise können die Spiegel mit einer Positioniergeschwindigkeit bis zu 15 m/s bewegt werden. Alternativ zu einem Galvanometer-Scanner kann auch ein anderer 2D-Spiegelscanner eingesetzt werden, beispielsweise ein MEMS-Spiegelscanner (Micro-Electro-Mechanical-System).

Das Strahlablenkelement weist gemäß einer bevorzugten Ausgestaltung eine elektronische Steuereinheit auf, mit der insbesondere die Winkelverteilung der Strahlablenkung einstellbar ist. Beispielsweise kann das Strahlablenkelement eine Computersteuerung aufweisen. Die Steuerung des Strahlablenkelements kann beispielsweise in eine Computersteuerung der Beleuchtungsvorrichtung und/oder der gesamten lithografisch Vorrichtung integriert sein.

Das Strahlhomogenisierungselement weist zur Erzeugung einer definierten Winkelverteilung der Strahlung vorzugsweise eine diffraktive Struktur auf. Das Strahlhomogenisierungselement ist gemäß zumindest einer Ausgestaltung ein diffraktives optisches Element (DOE). Das diffraktive optische Element kann zum Beispiel mindestens ein computergeneriertes Hologramm (CGH) aufweisen. Weiterhin kann das Strahlhomogenisierungselement ein refraktiv-diffraktives optisches Element sein, also ein Hybridelement, das gleichzeitig diffraktive Eigenschaften und refraktive wirkende Grenzflächen aufweist.

Gemäß einer vorteilhaften Ausgestaltung ist das Strahlhomogenisierungselement beweglich. Insbesondere kann das Strahlhomogenisierungselement eine elektronische Ansteuerung aufweisen, die dazu eingerichtet ist, das Strahlhomogenisierungselement beim Betrieb der Beleuchtungsvorrichtung zu bewegen. Die elektronische Ansteuerung kann eine Computersteuerung sein, die insbesondere in eine Computersteuerung der Beleuchtungseinheit und/oder der lithografischen Vorrichtung integriert sein kann. Das Strahlhomogenisierungselement kann insbesondere dazu eingerichtet sein, beim Betrieb der Beleuchtungseinheit eine Rotationsbewegung um mindestens eine Achse und/oder eine Translationsbewegung in mindestens einer Richtung auszuführen.

Insbesondere kann vorgesehen sein, dass das Strahlhomogenisierungselement um eine nicht kollinear zur optischen Achse der Beleuchtungsvorrichtung verlaufende Rotationsachse rotierbar ist, vielmehr ist die Rotationsachse zur optischen Achse parallel verschoben und/oder gekippt. Mit anderen Worten ist das Strahlhomogenisierungselement exzentrisch rotierbar.

Durch die Translations- und/oder Rotationsbewegung des Strahlhomogenisierungselements beim Betrieb der Beleuchtungseinheit wird vorteilhaft erreicht, dass zeitlich variierend verschiedene Bereiche des Strahlhomogenisierungselements, insbesondere der diffraktiven Struktur des Strahlhomogenisierungselements, in den Beleuchtungsstrahl bewegt werden. Auf diese Weise gelingt es insbesondere, örtlich hochfrequente Interferenzmuster, welche durch eine kohärente Beleuchtung mittels einer Laserlichtquelle entstehen können, zu minimieren und so den Beleuchtungsstrahl zu homogenisieren. Auf diese Weise wird vorteilhaft eine besonders homogene Winkelverteilung hinter dem Strahlhomogenisierungselement erzielt, die durch das nachfolgende Linsensystem aus der Fourierlinse und der Feldlinse in eine homogene Intensität- und Winkelverteilung in der Beleuchtungsebene einer Fotomaske transferiert wird.

Das Strahlhomogenisierungselement weist bei einer bevorzugten Ausgestaltung eine Vielzahl von diffraktiven optischen Elementen wie beispielsweise Hologrammen aus, die vorzugsweise in einer 2-dimensionalen Anordnung nebeneinander angeordnet sind. Durch die Bewegung des Strahlhomogenisierungselements können vorteilhaft verschiedene diffraktive Elemente durch den Beleuchtungsstrahl rotiert werden. Durch eine kontinuierliche Bewegung des Strahlhomogenisierungselements während eines Belichtungsvorgangs kann so eine Homogenisierung des Beleuchtungslichts erzielt werden. Es ist vorteilhaft auch möglich, durch gezielte Beleuchtung bestimmter Bereiche des Strahlhomogenisierungselements eine gewünschte Winkelverteilung des Beleuchtungslichts zu erzeugen.

Die Strahlquelle der Beleuchtungseinheit ist vorzugsweise eine Laserlichtquelle. Eine Laserlichtquelle hat insbesondere den Vorteil, dass eine polarisierte Beleuchtung erfolgen kann, ohne dass Lichtleistung an einem Polarisator verloren geht. Beispielsweise kann ein Excimerlaser wie beispielsweise ein ArF-Laser oder KrF-Laser oder ein Festkörperlaser wie zum Beispiel ein Nd:YAG-Laser als Strahlquelle eingesetzt werden. Alternativ ist auch denkbar, eine Laserdiode, eine LED oder eine Superkontinuum-Quelle als Strahlquelle einzusetzen. Die Laserlichtquelle kann mit einer Frequenzkonversion, insbesondere einer Frequenzverdoppelung oder Frequenzverdreifachung, betrieben werden. Dies ist insbesondere beim Festkörperlaser wie zum Beispiel einem Nd:YAG Laser von Vorteil, um eine vergleichsweise große Ausgangswellenlänge von z.B. 1064 nm in eine kürzere Wellenlänge von 532 nm oder 335 nm zu konvertieren. Die Verwendung von kurzen Wellenlängen ist in der Lithographie zur Erzielung einer hohen Auflösung von Vorteil.

Bei einer weiteren Ausgestaltung ist zwischen der Strahlquelle und dem Strahlablenkelement ein polarisierendes optisches Element angeordnet. Dies ist insbesondere dann vorteilhaft, wenn die Strahlquelle selbst nicht polarisiert ist. Das polarisierende optische Element kann zum Beispiel ein Drahtgitterpolarisator, eine A/2-Platte, eine A/4-Platte, eine Pockelszelle oder ein diffraktives optisches Element sein.

Es wird weiterhin eine lithografische Vorrichtung angegeben, welche zuvor beschriebene Beleuchtungsquelle und eine Fotomaske aufweist. Das Strahlhomogenisierungselement der Beleuchtungsquelle ist zur Erzeugung einer homogenen Winkelverteilung des auf die Fotomaske auftreffenden Beleuchtungslichts vorteilhaft in der Fourierebene der Fotomaske angeordnet.

Die Fotomaske weist insbesondere eine Maskenstruktur auf, die mittels des erzeugten Beleuchtungslicht in eine strahlungsempfindliche Polymerschicht (Resist) abgebildet wird. Die strahlungsempfindliche Polymerschicht kann beispielsweise auf einem Substrat angeordnet sein, dass im Strahlengang hinter der Fotomaske positioniert wird.

Weitere vorteilhafte Ausgestaltungen der lithografischen Vorrichtung ergeben sich aus der Beschreibung der Beleuchtungsquelle.

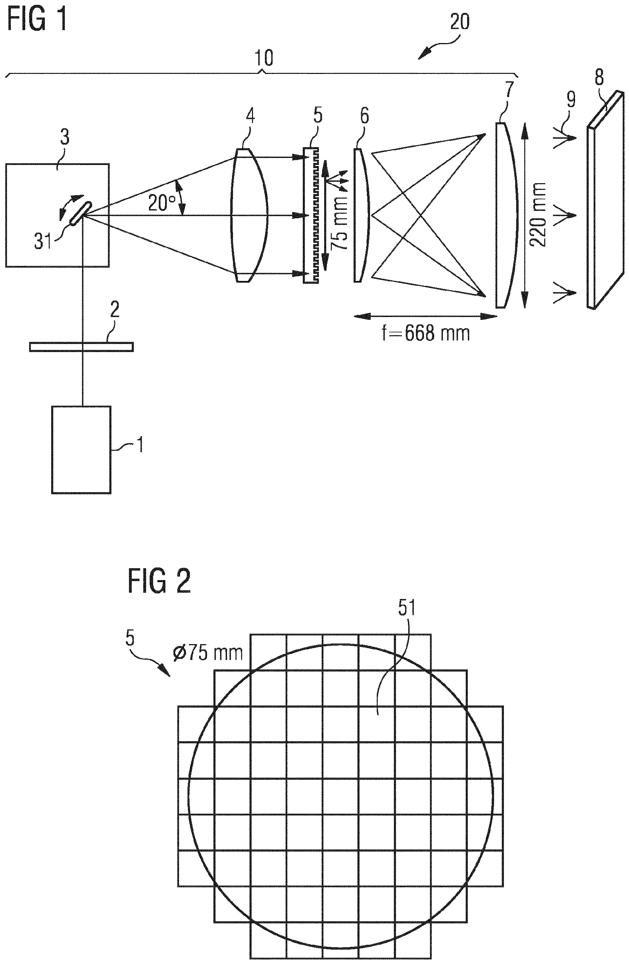

Die Erfindung wird im Folgenden anhand eines Ausführungsbeispiels im Zusammenhang mit den Figuren 1 und 2 näher erläutert.

Es zeigen:
Figur 1 eine schematische Darstellung einer Vorrichtung zur lithografischen Belichtung mit einer Beleuchtungseinheit gemäß einem Ausführungsbeispiel, und
Figur 2 eine schematische Darstellung des Strahlhomogenisierungselements bei dem Ausführungsbeispiel.

Die in den Figuren dargestellten Bestandteile sowie die Größenverhältnisse der Bestandteile untereinander sind nicht als maßstabsgerecht anzusehen.

Die in Figur 1 dargestellte Vorrichtung zur lithografischen Belichtung 20 enthält eine Beleuchtungseinheit 10, die dazu vorgesehen ist, eine Fotomaske 8 mit einem Beleuchtungslicht 9 zu beleuchten.

Die Beleuchtungseinheit 10 umfasst eine Strahlquelle 1, bei der es sich vorzugsweise um eine Laserlichtquelle handelt. Bei dem Ausführungsbeispiel wird beispielsweise ein Nd:YVO₄-Festkörperlaser mit einer durch Frequenzverdreifachung erzeugten Wellenlänge λ = 355 nm eingesetzt. Die Strahlquelle 1 kann zum Beispiel eine Leistung von etwa 1,5 W bis 4 W und einen Strahldurchmesser von etwa 1 mm aufweisen.

Bei Verwendung einer Laserlichtquelle als Strahlquelle 1 wird vorteilhaft polarisiertes Beleuchtungslicht 9 abgestrahlt, ohne dass Lichtintensität an einem Polarisator verloren geht.

Alternativ kann auch eine unpolarisierte Strahlquelle 1 eingesetzt werden. Es ist möglich, dass im Strahlengang ein polarisierendes optisches Element 2 angeordnet ist, welches die von der Strahlquelle 1 emittierte Strahlung 9 polarisiert oder den Polarisationszustand ändert. Das polarisierende optische Element 2 kann beispielsweise ein Drahtgitterpolarisator, eine A/2-Platte, eine A/4-Platte, eine Pockelszelle oder ein diffraktives optisches Element sein.

Der Strahlquelle 1 folgt im Strahlengang ein Strahlablenkelement 3 nach. Das Strahlablenkelement 3 ist bevorzugt ein 2D-Spiegelscanner, der zwei bewegliche Spiegel enthält, die vorteilhaft eine Strahlablenkung in zwei senkrecht aufeinander stehenden Achsen ermöglichen. In der in Figur 1 dargestellten Seitenansicht ist nur einer der beiden Spiegel 31 sichtbar, der beispielsweise eine Strahlablenkung in y-Richtung bewirkt. Ein weiterer in Figur 1 nicht sichtbarer Spiegel bewirkt eine zusätzliche Strahlablenkung in einer x-Richtung, die senkrecht zur Zeichenebene steht. Der 2D-Spiegelscanner kann beispielsweise ein Galvanometer-Scanner sein, bei dem die Spiegel 31 galvanisch angetrieben werden. Das Strahlablenkelement 3 kann zum Beispiel eine maximale Strahlablenkung von jeweils ± 20° in x- Richtung und y-Richtung ermöglichen.

Das Strahlablenkelement 3 ist vorzugsweise elektronisch ansteuerbar, insbesondere mit einer Computersteuerung. Das elektronisch ansteuerbare Strahlablenkelement 3 ermöglicht es insbesondere, den Strahl der Strahlquelle 1 durch eine schnelle zeitliche Variation der Strahlablenkung über eine zu beleuchtende Fläche zu scannen und auf diese Weise die Fläche auszuleuchten. Durch die Computersteuerung der Strahlablenkung ist es vorteilhaft möglich, die Form der ausgeleuchteten Fläche beliebig zu definieren, wobei die Grenzen im Wesentlichen nur durch die maximal mögliche Strahlauslenkung in x-Richtung und y-Richtung vorgegeben sind. Die ausgeleuchtete Fläche, über die der Strahl mittels des Strahlablenkelements 3 gescannt wird, kann beispielsweise eine kreisrunde oder rechteckige Form aufweisen. Alternativ sind aber auch beliebige andere geometrische Formen oder Muster möglich, insbesondere Zeichen, Buchstaben oder Zahlen.

Dem Strahlablenkelement 3 folgt im Strahlengang eine Kollimationslinse 4 nach, wobei die Lichteintrittsfläche der Kollimationslinse 4 durch die zeitlich variable Strahlauslenkung ausgeleuchtet wird. Durch die Kollimationslinse 4 wird die einfallende divergente Strahlung kollimiert, d.h. parallel gerichtet. Um eine gute Kollimation insbesondere auch in den Randbereichen der Kollimationslinse 4 zu erzielen, wird vorzugsweise eine asphärische Kollimationslinse 4 eingesetzt. Beispielsweise ist die dem Strahlablenkelement 3 zugewandte Lichteintrittsfläche der Kollimationslinse 4 zylindrisch und die gegenüberliegende Lichtaustrittsfläche asphärisch ausgebildet.

Hinter der Kollimationslinse 4 ist im Strahlengang ein Strahlhomogenisierungselement 5 angeordnet, auf das das von der Kollimationslinse 4 kollimierte Licht vorzugsweise senkrecht auftrifft. Das Strahlhomogenisierungselement 5 kann zum Beispiel einen Durchmesser von etwa 75 mm aufweisen. Das Strahlhomogenisierungselement 5 ist vorteilhaft kein statisches optisches Element, sondern ein vorzugsweise elektrisch ansteuerbares bewegliches Element. Das Strahlhomogenisierungselement 5 bewegt sich während des Betriebs der lithografischen Vorrichtung, insbesondere bei einem Belichtungsvorgang, vorzugsweise kontinuierlich. Die Bewegung des Strahlhomogenisierungselements 5 ist vorzugsweise eine Rotationsbewegung um mindestens eine Rotationsachse, die nicht gleich der optischen Achse der Beleuchtungseinheit ist. Vielmehr ist die Rotationsache des Strahlhomogenisierungselements 5 gegenüber der optischen Achse parallel verschoben und/oder gekippt. Es kann auch vorgesehen sein, dass die Rotationsachse des Strahlhomogenisierungselements 5 nicht ortsfest ist, sondern zeitlich variiert. Das Strahlhomogenisierungselement 5 kann beispielsweise eine Überlagerung mehrerer Rotationsbewegungen ausführen, was insbesondere durch ein Planeten-Getriebe realisiert werden kann.

Zusätzlich oder alternativ kann das Strahlhomogenisierungselement 5 eine Translationsbewegung ausführen, vorzugsweise eine Translationsbewegung in einer senkrecht zur optischen Achse verlaufenden Ebene, so dass sich die Position des Strahlhomogenisierungselements 5 auf der optischen Achse relativ zu den übrigen optischen Komponenten während der Bewegung nicht ändert.

Durch die Bewegung des Strahlhomogenisierungselements 5 wird vorteilhaft erreicht, dass während eines Belichtungsvorgangs verschiedene Bereiche des Strahlhomogenisierungselements 5 von dem Beleuchtungsstrahl getroffen werden. Auf diese Weise werden unerwünschte Interferenzeffekte wie zum Beispiel Speckles, die aufgrund einer kohärenten Strahlquelle 1 entstehen können, vermindert.

Das Strahlhomogenisierungselement 5 ist vorzugsweise ein diffraktives optisches Element, das zum Beispiel mindestens ein computergeneriertes Hologramm aufweist. Bei einer bevorzugten Ausgestaltung weist das Strahlhomogenisierungselement 5 eine Vielzahl von diffraktiven optischen Elementen 51 auf. Ein Beispiel für ein solches Strahlhomogenisierungselement 5 ist in Fig. 2 dargestellt. Die mehreren diffraktiven optischen Elemente 51 können beispielsweise zu einem zweidimensionalen Array zusammengefügt sein. Das Strahlhomogenisierungselement 5 weist zum Beispiel einen Durchmesser von etwa 75 mm auf. Auf der Fläche des Strahlhomogenisierungselements ist eine Vielzahl von diffraktiven Elementen 51 angeordnet, die zum Beispiel jeweils computergenerierte Hologramme sind. Die Größe der einzelnen diffraktiven Elemente entspricht vorzugsweise in etwa dem Strahldurchmesser der Strahlquelle 1, beispielsweise etwa 1 mm². Die mehreren diffraktiven optischen Elemente 51 weisen vorzugsweise dieselbe Funktion auf, insbesondere die Funktion, eine vorgegebene Winkelverteilung zu erzeugen. Diese Funktion wird bei den verschiedenen diffraktiven Elementen 51 aber durch verschiedene Interferenzmuster bewirkt. Bei dem dargestellten Ausführungsbeispiel wird von dem Strahlhomogenisierungselement beispielsweise eine Winkelverteilung von ± 9° erzeugt.

Auf das Strahlhomogenisierungselement 5 folgt im Strahlengang ein Linsensystem, das aus einer Fourierlinse 6 und eine Feldlinse 7 besteht. Der Abstand zwischen der Fourierlinse 6 und der Feldlinse 7 beträgt bei dem Ausführungsbeispiel etwa 668 mm. Dieser Abstand in Zusammenhang mit der vom Strahlhomogenisierungselement 5 generierten Winkelverteilung von ±9° erzeugt eine Beleuchtung von 220 mm im Durchmesser. Durch die Fourierlinse 6 wird die von dem Strahlhomogenisierungselement 5 erzeugte homogene Winkelverteilung von beispielsweise ± 9° in eine homogene Intensitätsverteilung in der Ebene der Feldlinse 7 umgesetzt. Die Feldlinse 7 kann beispielsweise einen Durchmesser von etwa 220 mm aufweisen. Um optische Abbildungsfehler insbesondere in den Randbereichen zu vermeiden, werden für die Fourierlinse 6 und die Feldlinse 7 vorzugsweise jeweils asphärische Linsen verwendet. Die Feldlinse 7 bewirkt vorteilhaft eine telezentrische Beleuchtung der im Strahlengang nachfolgenden Fotomaske 8. Das hinter der Feldlinse 7 auf die Fotomaske 8 auftreffende Beleuchtungslicht 9 hat beispielsweise eine homogene Winkelverteilung von ± 3°.

Bei einer bevorzugten Ausgestaltung ist die Winkelverteilung des Beleuchtungslichts 9, das auf die Fotomaske 8 auftrifft, durch die Winkelverteilung, die mit dem Strahlablenkelement 3 erzeugt wird, einstellbar. Durch eine Computersteuerung des Strahlablenkelements 3 kann so für einen Belichtungsvorgang gezielt eine gewünschte Winkelverteilung des Beleuchtungslichts 9 im Bereich der Fotomaske ausgewählt werden.
Die Erfindung ist nicht durch die Beschreibung anhand der Ausführungsbeispiele beschränkt. Die Erfindung wird durch die Ansprüche definiert.

## Patentansprüche

1. Beleuchtungseinheit (10) zur lithographischen Belichtung, umfassend folgende Elemente in der genannten Reihenfolge:
- eine Strahlquelle (1),
- ein elektronisch ansteuerbares Strahlablenkelement (3) zur Erzeugung einer zeitlich variierenden zweidimensionalen Strahlablenkung,
- eine Kollimationslinse (4),
- ein Strahlhomogenisierungselement (5),
- eine Fourierlinse (6), und
- eine Feldlinse (7).

2. Beleuchtungseinheit (10) nach Anspruch 1,
wobei das Strahlablenkelement (3) ein 2D-Spiegelscanner ist.

3. Beleuchtungseinheit (10) nach Anspruch 2,
wobei der 2D-Spiegelscanner ein Galvano-Scanner oder ein MEMS-Scanner ist.

4. Beleuchtungseinheit (10) einem der vorhergehenden Ansprüche,
wobei das Strahlablenkelement (3) eine elektronische Steuereinheit aufweist, mit der eine Winkelverteilung der Strahlablenkung einstellbar ist.

5. Beleuchtungseinheit (10) nach einem der vorhergehenden Ansprüche,
wobei das Strahlhomogenisierungselement (5) ein diffraktives optisches Element oder ein refraktiv-diffraktives optisches Element ist.

6. Beleuchtungseinheit (10) nach einem der vorhergehenden Ansprüche,
wobei das Strahlhomogenisierungselement (5) beweglich ist.

7. Beleuchtungseinheit (10) nach einem der vorhergehenden Ansprüche,
wobei das Strahlhomogenisierungselement (5) eine elektronische Ansteuerung aufweist, die dazu eingerichtet ist, das Strahlhomogenisierungselement (5) beim Betrieb der Beleuchtungseinheit (10) zu bewegen.

8. Beleuchtungseinheit (10) nach einem der vorhergehenden Ansprüche,
wobei das Strahlhomogenisierungselement (5) dazu eingerichtet ist, beim Betrieb der Beleuchtungseinheit eine Rotationsbewegung um mindestens eine Achse und/oder eine Translationsbewegung in mindestens einer Richtung auszuführen.

9. Beleuchtungseinheit (10) nach einem der vorhergehenden Ansprüche,
wobei das Strahlhomogenisierungselement (5) eine Anordnung einer Vielzahl von diffraktiven optischen Elementen (51) aufweist.

10. Beleuchtungseinheit (10) nach einem der vorhergehenden Ansprüche,
wobei die Strahlquelle (1) eine Laserlichtquelle ist.

11. Beleuchtungseinheit (10) nach einem der vorhergehenden Ansprüche,
wobei zwischen der Strahlquelle (1) und dem Strahlablenkelement (3) ein polarisierendes optisches Element (2) angeordnet ist.

12. Vorrichtung zur lithografischen Belichtung (20), umfassend
- eine Beleuchtungseinheit (10) gemäß einem der vorhergehenden Ansprüche, und
- eine Fotomaske (8).

13. Vorrichtung zur lithografischen Belichtung (20) nach Anspruch 12,
wobei die Feldlinse (7) der Beleuchtungseinheit (10) zur telezentrischen Ausleuchtung der Fotomaske (8) eingerichtet ist.

14. Vorrichtung zur lithografischen Belichtung (20) nach Anspruch 12 oder 13,
wobei das Strahlhomogenisierungselement (5) zur Erzeugung einer homogenen Winkelverteilung des auf die Fotomaske (8) auftreffenden Beleuchtungslichts (9) in einer Fourierebene der Fotomaske (8) angeordnet ist.

## Claims

1. Illumination unit (10) for lithographic exposure, comprising the following elements in the stated order:
- a beam source (1),
- an electronically drivable beam deflection element (3) for generating a temporally varying two-dimensional beam deflection,
- a collimation lens (4),
- a beam homogenizing element (5),
- a Fourier lens (6), and
- a field lens (7).

2. Illumination unit (10) according to Claim 1,
wherein the beam deflection element (3) is a 2D mirror scanner.

3. Illumination unit (10) according to Claim 2,
wherein the 2D mirror scanner is a galvano scanner or a MEMS scanner.

4. Illumination unit (10) according to any of the preceding claims,
wherein the beam deflection element (3) has an electronic control unit, by which an angle distribution of the beam deflection is settable.

5. Illumination unit (10) according to any of the preceding claims,
wherein the beam homogenizing element (5) is a diffractive optical element or a refractive-diffractive optical element.

6. Illumination unit (10) according to any of the preceding claims,
wherein the beam homogenizing element (5) is moveable.

7. Illumination unit (10) according to any of the preceding claims,
wherein the beam homogenizing element (5) has an electronic driving assembly designed to move the beam homogenizing element (5) during the operation of the illumination unit (10) .

8. Illumination unit (10) according to any of the preceding claims,
wherein the beam homogenizing element (5) is designed to perform a rotational movement about at least one axis and/or a translational movement in at least one direction during the operation of the illumination unit.

9. Illumination unit (10) according to any of the preceding claims,
wherein the beam homogenizing element (5) has an arrangement of a multiplicity of diffractive optical elements (51).

10. Illumination unit (10) according to any of the preceding claims,
wherein the beam source (1) is a laser light source.

11. Illumination unit (10) according to any of the preceding claims,
wherein a polarizing optical element (2) is arranged between the beam source (1) and the beam deflection element (3).

12. Device for lithographic exposure (20), comprising
- an illumination unit (10) according to any of the preceding claims,
- a photomask (8).

13. Device for lithographic exposure (20) according to Claim 12,
wherein the field lens (7) of the illumination unit (10) is designed for the telecentric illumination of the photomask (8) .

14. Device for lithographic exposure (20) according to Claim 12 or 13,
wherein the beam homogenizing element (5) for generating a homogenous angle distribution of the illumination light (9) impinging on the photomask (8), is arranged in a Fourier plane of the photomask (8).

## Revendications

1. Module d'éclairage (10) destiné à l'éclairage lithographique, comprenant les éléments suivants, dans l'ordre chronologique cité :
- une source de rayonnement (1),
- un déflecteur de rayonnement (3) à activation électronique, destiné à générer une déflexion de rayonnement bidimensionnelle, variant dans le temps,
- une lentille de collimation (4),
- un élément d'homogénéisation du faisceau (5),
- une lentille de Fourier (6) et
- une lentille de champ (7).

2. Module d'éclairage (10) selon la revendication 1, le déflecteur de rayonnement (3) étant un scanner à miroir en 2D.

3. Module d'éclairage (10) selon la revendication 2, le scanner à miroir en 2D étant un scanner galvanique ou un scanner MEMS.

4. Module d'éclairage (10) selon l'une quelconque des revendications précédentes, le déflecteur de rayonnement (3) comportant un module électronique de commande, permettant de régler une distribution angulaire de la déviation de faisceau.

5. Module d'éclairage (10) selon l'une quelconque des revendications précédentes, l'élément d'homogénéisation du faisceau (5) étant un élément optique diffractif ou un élément optique réfractif- diffractif.

6. Module d'éclairage (10) selon l'une quelconque des revendications précédentes, l'élément d'homogénéisation du faisceau (5) étant mobile.

7. Module d'éclairage (10) selon l'une quelconque des revendications précédentes, l'élément d'homogénéisation du faisceau (5) comportant un amorçage électronique qui est aménagé pour déplacer l'élément d'homogénéisation du faisceau (5) lors du fonctionnement du module d'éclairage (10).

8. Module d'éclairage (10) selon l'une quelconque des revendications précédentes, l'élément d'homogénéisation du faisceau (5) étant aménagé pour réaliser, lors du fonctionnement du module d'éclairage, un déplacement en rotation autour d'au moins un axe et/ou un déplacement en translation dans au moins une direction.

9. Module d'éclairage (10) selon l'une quelconque des revendications précédentes, l'élément d'homogénéisation du faisceau (5) comportant une configuration d'une pluralité d'éléments optiques diffractifs (51).

10. Module d'éclairage (10) selon l'une quelconque des revendications précédentes, la source de rayonnement (1) étant une source de lumière laser.

11. Module d'éclairage (10) selon l'une quelconque des revendications précédentes, entre la source de rayonnement (1) et le déflecteur de rayonnement (3) étant placé un élément optique (2) polarisant.

12. Dispositif destiné à l'éclairage lithographique (20), comprenant
- un module d'éclairage (10) selon l'une quelconque des revendications précédentes et
- un photomasque (8).

13. Dispositif destiné à l'éclairage lithographique (20) selon la revendication 12, la lentille de champ (7) du module d'éclairage (10) étant aménagée pour l'éclairage télécentrique du photomasque (8).

14. Dispositif destiné à l'éclairage lithographique (20) selon la revendication 12 ou 13, pour la création d'une distribution angulaire homogène de la lumière d'éclairage (9) incidente sur le photomasque (8), l'élément d'homogénéisation du faisceau (5) étant placé dans un plan de Fourier du photomasque (8).
